# EUROPEAN PATENT SPECIFICATION

(11) **EP 1 366 203 B1**
(45) Date of publication and mention of the grant of the patent: **13.09.2006**
(21) Application number: 02726582.6
(22) Date of filing: 20.02.2002
(51) Int. Cl.: C22C 27/02, C23C 14/34, C22F 1/18

(54) **REFRACTORY METAL PLATES WITH UNIFORM TEXTURE AND METHODS OF MAKING THE SAME**
PLATTEN AUS REFRAKTÄREM METALL MIT EINHEITLICHER TEXTUR UND VERFAHREN ZU IHRER HERSTELLUNG
PLAQUES METALLIQUES REFRACTAIRES A TEXTURE UNIFORME ET LEURS PROCEDES DE FABRICATION

(30) Priority: 20.02.2001 US 269983 P
(43) Date of publication of application: 03.12.2003
(73) Proprietor: H. C. Starck, Inc., Newton, MA 02461 (US)
(72) Inventor: JEPSON, Peter R., Newton, MA 02461 (US); UHLENHUT, Henning, Newton, MA 02461-1951 (US); KUMAR, Prabhat, Newton, MA 02461 (US)
(74) Representative: Feldhues, Michael L.F.
(86) International application number: PCT/US2002/005033
(87) International publication number: WO 2002/070765

(56) References cited:
- EP-A- 1 053 810
- EP-A- 1 066 899
- EP-A2- 1 066 899
- WO-A-01/96620
- WO-A-99/02743
- WO-A2-01/96620
- US-A- 5 456 815
- US-A- 5 850 755
- US-A1- 2001 054 457
- US-B1- 6 238 494
- US-B1- 6 331 233
- US-B1- 6 348 113
- US-B1- 6 348 139

## Description

### FIELD OF THE INVENTION

This invention relates generally to improved refractory metal plates usable as sputtering targets and for other purposes to form a plate with high purity, fine grain-size, high-strength, uniform texture structure.

### BACKGROUND OF THE INVENTION

Sputter targets are used in a plasma sputter process to produce thin metal films that are used in various applications, for example as a surface on which vapor bubbles are formed in an ink-jet printer, and for another example, as a barrier layer between copper and silicon in an integrated electronic circuit. Thin films of tantalum oxide are also of practical value, for example in wavelength-division-multiplex (WDM) devices, and, potentially, in electrical capacitors.

Refractory metal sputtering targets exemplify a broader need for microstructural uniformity in refractory metal plates. With targets made by prior art, the heterogeneity of texture found in the sputtering target plate manufactured with known processes cause unpredictability in the sputtering rate (defined as the number of metal atoms sputtered onto the substrate per impinging sputter gas, such as argon ion). Also, heterogeneity of texture causes heterogeneity of the direction in which sputtered atoms leave the target. Unpredictability of sputtering rate and sputtering direction causes variation of the thickness of the film produced from point to point on the substrate, and also causes variation of average thickness of the film produced on the substrate from substrate to sustrate, and from target to target.

In many sputtering applications, the thickness of the film is of prime importance and needs to be controlled closely. In integrated circuits, for example, too thin a film will not provide a barrier, and too thick a film will block a via or trench. In WDM devices, the tantalum oxide layer thickness needs to be very close to one-quarter of a wavelength of the light passing through it. If the thickness of the film deposited is not within the range specified by the designer, the device will not be fit for service, and the total cost of manufacture up to the point of test is lost, since no repair or rework is normally possible.

The aspect of sputtering performance which is most hard to achieve is uniformity of thickness of the thin film produced on a substrate over its whole area, which is usually of the same shape as the target, but somewhat smaller. Typically, the target and substrate are parallel. The thickness of the thin film at any given point is a result of the atoms that have landed at that point. Most of those atoms will have come from a circular area of the target centered directly opposite the given point. That circular area on the target will be of the order of 1 cm radius. Therefore, if the sputtering rate of such a circle is the same wherever the circle lies on the surface of the target, a thin film of perfectly uniform thickness will be deposited, unless there are features of the equipment or its operation which cause non-uniformity.

The sputtering rate of such a circle, defined as the average number of atoms sputtered from it per second, will be an integral of the number of atoms sputtered from each grain within the circle. Grains with different orientations sputter at different rates. Thus if circle #1 is made up predominantly of grains with orientation A, where A is a slow-sputtering orientation, it will have an overall sputtering rate slower than circle #2, if circle #2 is made up predominantly of grains with orientation B, where B is a fast-sputtering orientation. However, if each circle is made up of the same mix of grains (for example, predominantly A, or for another example, an constant mix of grains with orientation A and grains with orientation B), the sputtering performance will improve. Therefore, a uniform texture provides a more controlled film thickness because the sputter rate is more predictable.

US Pat. No. 6,331,233 in Turner asserts uniform texture throughout the plate thickness from the outer edge to the center of the plate. However, the strain history of the material at the center is different from that at the edge. The difference occurs during "Deformation Stage 2," when the material is upset-forged. During upset forging, the material at the edge or high radius gets a moderate level of strain. The material at the center of the plate or low radius gets a low level of strain near the top or bottom surface and a high level of strain if it is at mid-thickness. Even after annealing, rolling and re-annealing, the difference in strain would be expected to affect the texture.

Even with state-of-the-art sputtering equipment, it is impossible to control the variation of thickness of the thin film from one point on the substrate to another using targets with non-uniform properties. Partial, but not total, control of variation of thickness from substrate to substrate, and from target to target, is possible using test-pieces. Use of test-pieces, however, is time-consuming and costly. Use of forging techniques, such as upset-and-forge-back, with recrystallization heat-treatments that introduces redundant work and thereby improves homogeneity of microstructure is well known. However, such techniques are susceptible to cause various types of defect in the worked metal, for example cracks, folds and mis-shapes, any of which will reduce the proportion of the worked metal which can be used as targets (ie. reduce the yield). The propensity of the material to crack is often reduced by heating it to a temperature in the region of 500°F 260 °C to 600°F 316 °C for the forging operations, but such heating is expensive, makes the work-piece harder to handle (so its final shape is further from the desired shape), and may result in an increase in oxygen content, particularly near the surface. Also, other forging techniques (those generally known as upset-bar forging) give product with texture that, although axi-symmetric, varies with radius, from the center out to the edge. Use of powder-metallurgy techniques to achieve uniform texture is also known. However, these techniques are generally not preferred because of higher cost, and because consolidated-powder parts may include voids, and may include non-metallic inclusions, both of which are undesirable for sputtering performance.

For the purpose of the invention, the texture is described as uniform when the texture of one area of an article is not measurably different from that of any other area of the article, except as expected from statistical theory. The uniform texture is not dependent on the size of the article or size of the area.

It is therefore an object of the present invention to provide a sputtering target that improves the predictability of the thickness of the films produced, and thus improve the ease of use of the targets.

It is a further object of the invention to provide classes of tantalum and niobium products of enhanced microstructural uniformity and method of making the same.

It is a further object of the present invention to provide a sputtering target manufactured from a given mass of tantalum ingot, thus improving the cost-efficiency of the process.

The present invention comprises a method of forming sputtering targets and other plate products from ingots of refractory metals of requisite purity by the process of cutting the ingot to short length pieces and pressure working the pieces along alternating essentially orthogonal work axes. Intermediate anneals are applied as necessary to establish a uniform texture throughout the target, including the center. The uniform texture is a constant mix of grains with orientation {100} and {111}, where these sets of numbers refer to the Miller indices of the set of crystallogrphic plane that is parallel or nearly parallel to the sputtered surface. The constant mix of grain orientation thereby improves sputtering performance by providing a more predictable sputter rate to control film thickness. The invention relates to a refractory metal plate comprising a thickness, a center, and an edge, the metal being selected from the group consisting of tantalum and niobium, said metal being of at least 99.99% purity, the plate having a grain size of less than about 40 microns and a texture that is uniform both through said thickness and from said center to said edge, and further wherein said refractory metal plate has
i) a constant mix of grains with orientation {100} and {111} crystallographic orientations, and
ii) a distribution of {100} and {111} crystallographic orientations that varies by less than 30 percent across the surface of any plane of said refractory metal plate, said planes being selected from planes that are orthogonal to the thickness of said refractory metal plate, and planes that are diagonal to the thickness of said refractory metal plate, and
iii) a distribution of {100} and {111} crystallographic orientations that varies by less than 30 percent across any thickness of said refractory metal plate.

The refractory metal plate may be obtained by a process comprising forging, rolling and annealing.
More specifically, the refractory metal plate according to the invention comprises a metal selected from the group consisting of tantalum, alloys of tantalum, niobium, alloys of niobium, said metal being preferably of at least 99.999% purity.
Sputtering targets preferably comprise a refractory metal plate according to the invention; the invention thus also relates to the use of the refractory metal plate according to the invention as a sputtering target.

Additionally, the present invention offers a process that produces a high purity refractory metal material having a unique combination of fine grain structure and uniform texture.

The invention also relates to a process for producing a refractory metal plate wherein the metal comprises a metal selected from the group consisting of tantalum, alloys of tantalum, niobium, alloys of niobium, said metal being of at least 99.99% purity, with fine metallurgical structure and uniform texture comprising:
a) providing a refractory metal starting piece;
b) first reducing the length of the refractory metal starting piece to form a first workpiece by forging the billet to a desired billet thickness with about 35% to 50% reduction; [first forging 14]
c) recrystallization annealing the first workpiece at a first temperature of at least 1370°C;
d) second reducing the diameter of the first workpiece (draw back forging) to a diameter substantially the same as a diameter of the refractory metal starting piece to form a second workpiece;
e) recrystallization annealing the second workpiece at a second temperature of at least 875°C;
f) repeating steps b) to e) as necessary to achieve desired grain structure and texture uniformity;
g) third reducing the second workpiece to a first thickness to form a first plate;
h) fourth reducing the first thickness of the first plate by cross rolling to a second thickness to form a second plate; and
i) recrystallization annealing the second plate at a temperature of at least 875°C.

In the process according to the invention, steps b) to g) may be repeated at least one time.
In the process according to the invention, the metal billet is preferably forged at a temperature below the minimum temperature of recrystallization of said billet.
In the process according to the invention, the metal billet preferably comprises a metal selected from the group consisting of tantalum, alloys of tantalum, niobium, alloys of niobium, said metal being preferably of at least 99.999% purity.

The invention also relates to the use of the refractory metal plate prepared by the process according to the invention as a sputtering target.

The invention is applicable to plates of flat or curved forms (including roll-up to cylinder or semi-circular or arc or conical forms). The plates can be used to advantage on account of their microstructures and grain uniformity as sputtering, furnace parts, aerospace and engine parts, as products of containers and patches for highly corrosive chemical environments. The plates can also be unbroken or can be drilled with holes or can be an expanded mesh (slit and edges pulled).

Other objects, features and advantages will be apparent from the following detailed description of preferred embodiments taken in conjunction with the accompanying drawings in which:

### BRIEF DESCRIPTION OF THE DRAWINGS

FIG. 1 is a flow chart of the process of the present invention;
FIG. 2 is a photograph of a tantalum target made according to the FIG. 1 process;
FIGS. 3 and 4 are similar photos of used tantalum targets made with coarse-grained or banded texture material;
FIG. 5 is a magnified photograph (400 µm scale-bar) illustrating the grain orientation in imaging microscope shots of a partial cross-section of a target, showing the orientation of each grain relative to the normal direction according to the present invention;
FIG 6 is a magnified photograph (400 µm scale-bar) illustrating the grain orientation in imaging microscope shots of a partial cross-section of a target, showing the orientation of each grain relative to within plane direction according to the present invention;
FIG. 7 is a magnified photograph (500 µm scale-bar) illustrating the grain orientation in imaging microscope shots of a partial cross-section of a target, showing the orientation of each grain relative to the normal direction according to the prior art;
FIG. 8 is a photograph illustrating a macro-etched surface of a plate formed according to a known prior art process illustrating the non-uniformity of the surface texture; and
FIG. 9 is a photograph illustrating a macro-etched surface of a plate formed according to the present invention illustrating the uniformity of the surface texture.

### DETAILED DESCRIPTION OF PREFERRED EMBODIMENTS

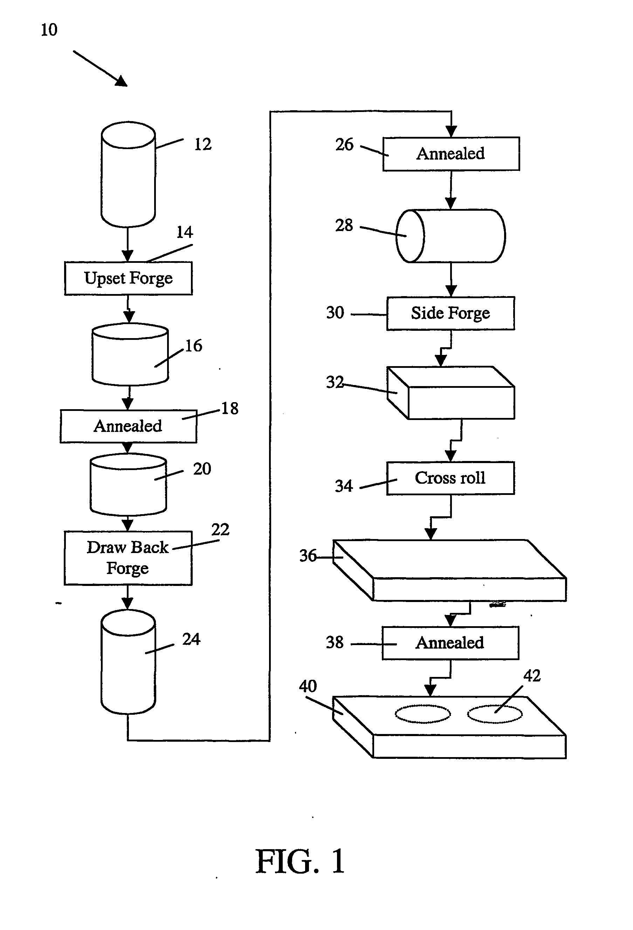

Now referring to FIG. 1, practice of a preferred embodiment of the present invention (method steps 10) starts with a refractory metal ingot 11, preferably tantalum ingot, typically of 8" diameter of very high purity, preferably 99.999%, with an impurity content suitable for the end use. After cleaning the surface of the ingot by machining, the ingot is cut into initial workpieces 12 of lengths between 1.5 times and 3 times the diameter, or approximately 12 inches to 24 inches. The first forging operation (step 14) reduces each initial workpiece 12 along its longitudinal axis by 35 to 50% to form first forged workpiece 16. First forged workpiece 16 is then annealed (step 18) at
l''=2.54 cms 1370°C, in vacuum or inert gas to cause recrystallization to produce a second workpiece form 20. The second forging operation (step 22) is then applied to forge the second workpiece form 20 in the longitudinal axis substantially back to approximately the diameter of initial workpiece 12, ranging from 80% to 120% of the diameter of initial workpiece 12. Second workpiece form 20 is laid on its side and flat or curved dies, such as swaging dies, are used to draw back forge in second forging operation (step 22) the second workpiece form 20 to form third workpiece form 24. This is done by impacting with sufficient force to substantially regain the original shape of initial workpiece 12. Second workpiece form 20 is turned between forging cycles for even cold working to induce a constant strain through the piece. All forging is done at room temperature with allowance for natural heating of the workpiece. However, it is preferred that the workpiece not exceed 800°F. All forging is preferably done on a press, rather than a hammer, to reduce the strain rate and allow better control of the shape of the workpiece. Third workpiece form 24 is annealed (step 26) at at least 875°C for tantalum and its alloys, in vacuum or inert gas to recrystallize a fourth workpiece form 28. The upset-forge-back cycle (steps 14 and 22) may be repeated as many times as necessary to achieve uniform texture of the plate.

Where appropriate to refine microstructure, or if necessary to avoid cracks, or excessive press loads, extra annealing treatments, at a lower temperature such as 1065°C, may be used at any point during the forging process.

A third forging operation (step 30), preferably side forge, flattens the fourth workpiece form 28 to form sheetbar 32, preferably approximately 4" thick. The sheetbar is cross-rolled (step 34) to reduce its thickness, typically ranging from 0.25 inches to 0.5 inches, to form plate 36. Cross-rolling (step 34) is arranged such that approximately equal strain in two orthogonal directions is achieved. Following the cross-rolling, plate 36 is annealed (step 38) at a relatively low temperature ranging from 875°C to 1065°C to form plate 40 of fully-recrystallized fine grain structure and uniform texture. Subsequently, the component shape 42 will be cut from the plate and bonded to a backing plate assembled in sputtering equipment for use as a sputtering target.
l''=2.54 cms

One embodiment of the invention preferably utilizes two upset-forgeback steps, performed on a press and one extra annealing cycle after the second upset-forgeback cycle before flattening to a slab.

The effectiveness and advantages of the products and processes of the present invention will be further illustrated by the following non-limiting examples.

### EXAMPLE 1

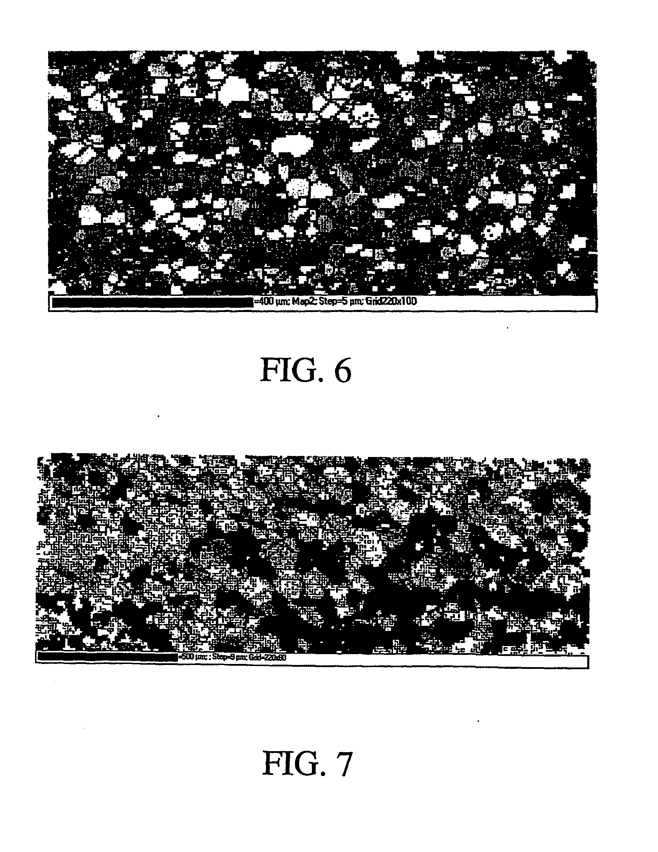

This example illustrates a product, made by a conventional prior art method (side-forging and unidirectional rolling of an ingot section), having an average grain size 30 µm linear intercept and a banded texture, as illustrated in FIG. 7.

### EXAMPLE 2

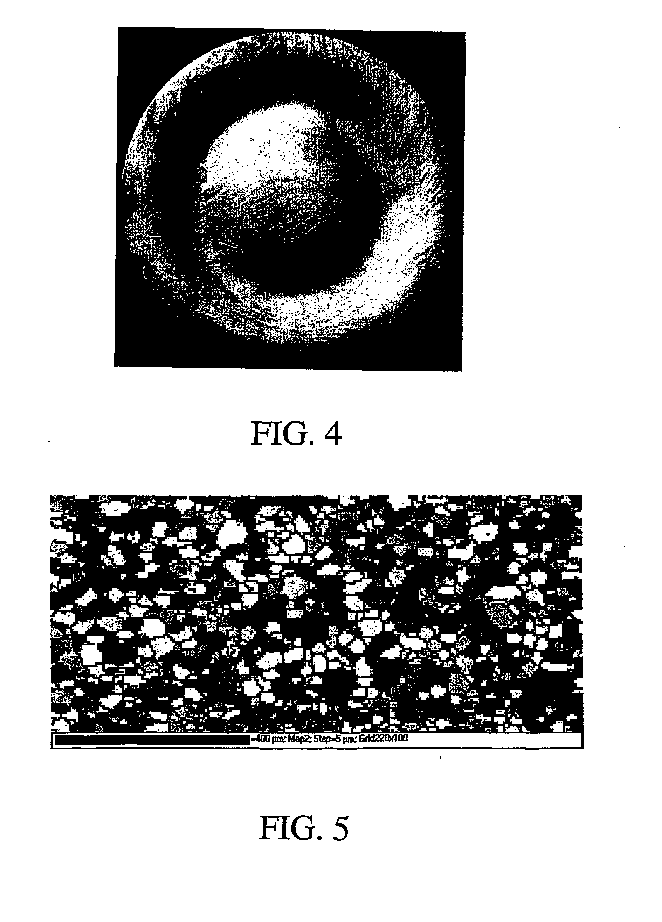

A tantalum plate, having a normal thickness and approximately 99.99% purity, was made by a preferred embodiment process of the present invention as described above and illustrated in FIG. 1. A tantalum ingot of about 8" diameter was cut into workpieces approximately 1.5 to 3 times the ingot diameter. The workpieces were upset forged by about 40% of original length and annealed to about 1370°C. Next, the workpieces were drawback forged to around the original 8" diameter, re-upset by approximately 40% of original length, drawn back to about 7.25" diameter, and annealed at atmosphere of about 1065°C. The workpieces were side forged to a sheetbar of about 4" thickness, cross rolled to a plate of about 0.500" thickness, and annealed at atmosphere of about 1065°C. The resulting plate had an average grain size of 30 µm linear intercept and a uniform texture without banding as illustrated in FIGS. 5 and 6.
l''=2.54 cms

### EXAMPLE 3

A tantalum plate made by the same process as Example 2 but with a tantalum ingot of 99.999% purity. The resultant plate has an average grain size of 35 µm linear intercept and the texture is uniform without banding.

### EXAMPLE 4

It would be feasible to apply the same process as Example 2, but with a tantalum ingot of 99.999% purity and a lower final annealing temperature of about 875°C. The resultant plate would have an average grain size of 15µm linear intercept due to the lower annealing temperature and low levels of impurity. The uniform texture is expected since the process of Example 2 has demonstrated texture without banding with substantially the same material.

### EXAMPLE 5

It would be feasible to apply the same process as Example 2, but with a tantalum ingot of 99.999% purity and the rolled thickness is around 0.800". The resultant plate would have an average grain size of 38 µm linear intercept. The texture is expected to be uniform without banding since the preferred invention ensures texture uniformity even when the strain introduced during rolling is lower than normal.
l''=2.54 cms

### EXAMPLE 6

It would be feasible to apply the same process as Example 2, but with a niobium ingot of 99.99% purity. The niobium plate of 0.500" thickness is expected to have an average grain size of 30µm linear intercept and a uniform texture without banding based on the comparable results of tantalum. The niobium plate is expected to perform similarly to the tantalum plate because their physical characteristics are similar.
l''=2.54 cms

### EXAMPLE 7

An alternative embodiment replaces the upset-drawback forging operations process with the well-known process of Equal Channel Angular Extrusion (ECAE); see e.g. US patents 5,400,633, 5,513,512, 5,600,989 and published US applications 2001/0001401, 2001/0054457, 2002/0000272, and 2002/0007880 of Segal et al. The ECAE process includes four C-type passes, anneal at 800°C, four C-type passes, and anneal at 800°C with 99.99% purity tantalum. The resultant product has an average grain size 8 µm linear intercept.

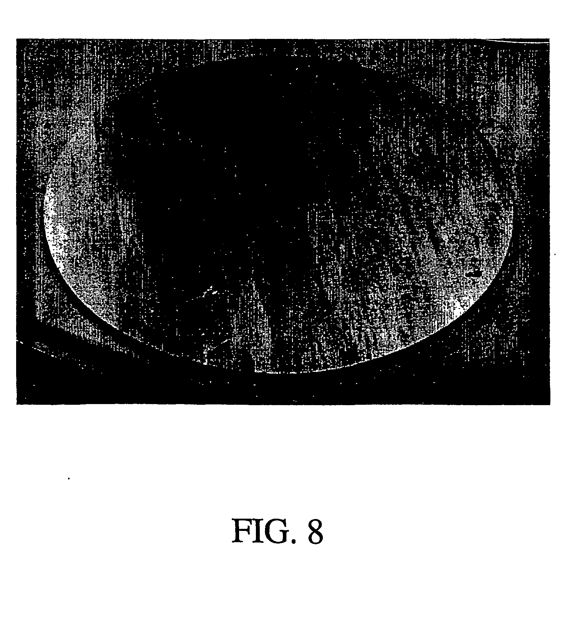

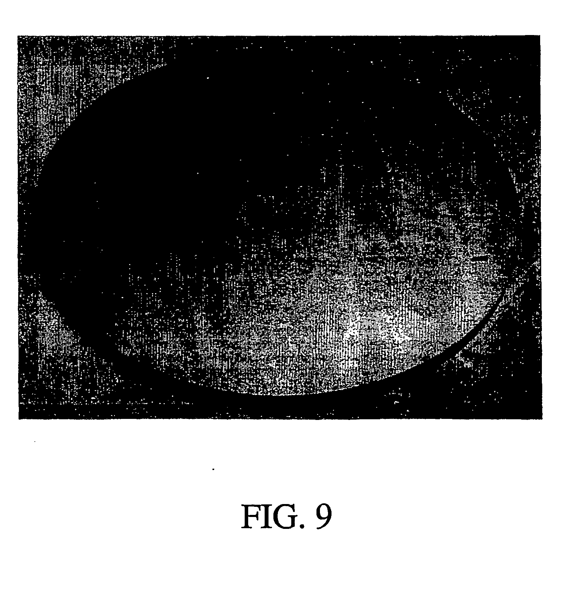

The uniformity of the microstructure, e.g., grain size and texture, is shown in FIGS. 5 and 6 to have improved grain orientation than with the prior art (a uniform patterns of similar random distribution), shown in FIG. 7 (in-homogeneity with non-random distribution). Another way of illustrating the uniformity is by examining the macrostructure of the plate surface, which is revealed by etching in an acid solution containing hydrofluoric acid. The improved process is illustrated in Fig. 9 contrasted to the prior art process represented in FIG. 8.

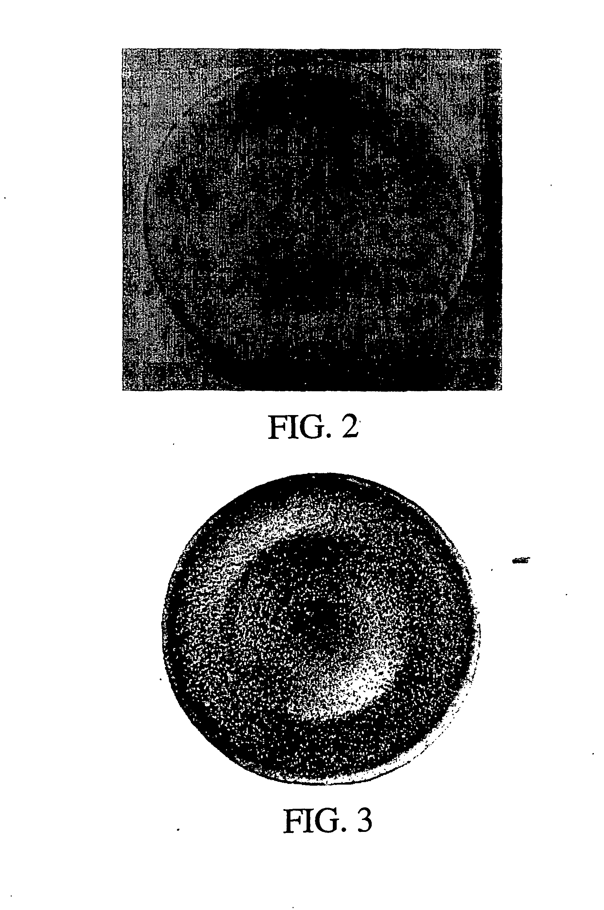

As a result of the uniform texture, the surface of the used sputtering target, as illustrated in FIG. 2, has a uniform appearance, in contrast to the speckled appearance caused by coarse grains or swirling pattern caused by banded texture, common with targets made by prior art, illustrated in FIGS. 3 and 4. In particular, the texture is uniform across the entire plate and uniform through the thickness from the center of the plate to the edge of the plate with no preferred direction within the plate, such as predominantly {100} or {111}. The uniform texture is a substantially constant mix of {100} and {111} crystallographic orientations. The distribution of {100} and {111} crystallographic orientations in any given plane of the plate (orthogonal or diagonal to the thickness) varies less than 30 percent across the surface of such plane and the variation across any thickness less than 30 percent. Plates of thickness less than 0.5" will be of predominantly {111} and plates of thickness of at least 0.5" will be of predominantly {100}. Additionally, FIG. 2 illustrates the coarse grained material inherent to the prior art process.
l''=2.54 cms

Also, the uniform texture is combined with a fine grain size, typically ASTM 7 to 8.8, when measured per test method ASTM E112. The present invention provides plates up to at least 0.8" thick to be made with these desirable properties. In prior art, the uniformity of the texture and grain size, and the fineness of the grain, deteriorated with thickness over about 0.5".
l''=2.54 cms

The introduction of a first intermediate anneal after the first upset-forge operation results in a much-decreased propensity of the material to crack in the subsequent metalworking operations. It also removes the need to heat the material for subsequent forging operations.

Reference to each of tantalum and niobium includes its alloys including tantalum-niobium alloys as well as other alloys of each, and also laminates and other composites of each with other materials. The invention applies to form and use of these metals and derivatives (such as oxides) as well as methods of producing the same. The uses of the plates or other forms of the metals include sputtering targets usage but can also include direct use of the plates for chemical, medical, electrical, high temperature resistance applications (furnace parts, aerospace foils, turbine blades).

## Claims

1. A refractory metal plate comprising a thickness, a center, and an edge, the metal being selected from the group consisting of tantalum and niobium, said metal being of at least 99.99% purity, the plate having a grain size of less than about 40 microns and a texture that is uniform both through said thickness and from said center to said edge, and further wherein said refractory metal plate has
i) a constant mix of grains with orientation {100} and {111} crystallographic orientations, and
ii) a distribution of {100} and {111} crystallographic orientations that varies by less than 30 percent across the surface of any plane of said refractory metal plate, said planes being selected from planes that are orthogonal to the thickness of said refractory metal plate, and planes that are diagonal to the thickness of said refractory metal plate, and
iii) a distribution of {100} and {111} crystallographic orientations that varies by less than 30 percent across any thickness of said refractory metal plate.

2. The refractory metal plate of claim 1, wherein said refractory metal plate was obtained by a process comprising forging, rolling and annealing.

3. The refractory metal plate of claim 1, wherein the metal billet comprises a metal selected from the group consisting of tantalum, alloys of tantalum, niobium, alloys of niobium, said metal being of at least 99.999% purity.

4. A sputtering target comprising a plate according to any of claims 1 to 3.

5. A process for producing a refractory metal plate wherein the metal comprises a metal selected from the group consisting of tantalum, alloys of tantalum, niobium, alloys of niobium, said metal being of at least 99.99% purity, with fine metallurgical structure and uniform texture comprising:
a) providing a refractory metal starting piece;
b) first reducing the length of the refractory metal starting piece to form a first workpiece by forging the billet to a desired billet thickness with about 35% to 50% reduction; [first forging 14]
c) recrystallization annealing the first workpiece at a first temperature of at least 1370°C;
d) second reducing the diameter of the first workpiece (draw back forging) to a diameter substantially the same as a diameter of the refractory metal starting piece to form a second workpiece;
e) recrystallization annealing the second workpiece at a second temperature of at least 875°C;
f) repeating steps b) to e) as necessary to achieve desired grain structure and texture uniformity;
g) third reducing the second workpiece to a first thickness to form a first plate;
h) fourth reducing the first thickness of the first plate by cross rolling to a second thickness to form a second plate; and
i) recrystallization annealing the second plate at a temperature of at least 875°C.

6. The process of claim 5, wherein steps b) to g) are repeated at least one time.

7. The process of claim 5, wherein the metal billet is forged at a temperature below the minimum temperature of recrystallization of said billet.

8. The process of claim 5, wherein the metal billet comprises a metal selected from the group consisting of tantalum, alloys of tantalum, niobium, alloys of niobium, said metal being of at least 99.999% purity.

9. Use of the metal plate prepared by the process of any of claims 5 to 8 as a sputtering target.

## Patentansprüche

1. Feuerfeste Metallplatte, umfassend eine Dickenerstreckung, ein Zentrum und eine Kante, wobei das Metall aus der Gruppe, bestehend aus Tantal und Niob, ausgewählt ist, das genannte Metall eine Reinheit von mindestens 99,99 % und die Platte eine Korngröße von weniger als ca. 40 µm und ein Gefüge aufweisen, das einheitlich sowohl durch die genannte Dicke hindurch als auch vom genannten Zentrum zur genannten Kante ist, und worin ferner die genannte feuerfeste Metallplatte aufweist:
i) einen konstanten Mix von Körnern mit {100} - und {111} -Orientation der kristallografischen Orientationen,
ii) eine Verteilung der {100}- und {111}-Kristallorientationen, die lediglich um weniger als 30 % über die Oberfläche jeder Ebene der genannten feuerfesten Metallplatte abweicht, wobei die genannten Ebenen aus Ebenen, die orthogonal zur Dicke der genannten feuerfesten Metallplatte verlaufen, und aus Ebenen ausgewählt sind, die diagonal zur Dicke der genannten feuerfesten Metallplatte verlaufen, und
iii) eine Verteilung der {100}- und {111}-Kristallorientationen, die um lediglich weniger als 30 % über jede Dicke der genannten feuerfesten Metallplatte abweicht.

2. Feuerfeste Metallplatte gemäß Anspruch 1, worin die genannte feuerfeste Metallplatte mit einem Verfahren erhalten wurde, das Schmieden, Walzen und Glühen umfasst.

3. Feuerfeste Metallplatte gemäß Anspruch 1, worin der Metallblock ein Metall umfasst, das aus der Gruppe, bestehend aus Tantal, Tantallegierungen, Niob und aus Nioblegierungen, ausgewählt ist, wobei das genannte Metall eine Reinheit von mindestens 99,999 % aufweist.

4. Spucker-Target, umfassend eine Platte gemäß einem der Ansprüche 1 bis 3.

5. Verfahren zur Erzeugung einer feuerfesten Metallplatte, worin das Metall ein Metall umfasst, das aus der Gruppe, bestehend aus Tantal, Tantallegierungen, Niob und aus Nioblegierungen, ausgewählt ist, wobei das genannte Metall eine Reinheit von mindestens 99,99 % mit metallurgischer Feinstruktur und einheitlichem Gefüge aufweist, umfassend:
a) Bereitstellen eines feuerfesten Metall-Ausgangsstücks;
b) erstes Absenken der Länge des feuerfesten Metall-Ausgangsstücks zur Bildung eines ersten Werkstücks durch Schmieden des Blocks auf eine gewünschte Blockdicke mit einer Absenkung um ca. 35 bis 50 % [erstes Schmieden];
c) Umkristallisationsglühen des ersten Werkstücks bei einer Temperatur von mindestens 1.370°C;
d) zweites Absenken des Durchmessers des ersten Werkstücks (Zug-Rückschmieden) auf einen im Wesentlichen gleichen Durchmesser wie den des feuerfesten Metall-Ausgangsstücks zur Bildung eines zweiten Werkstücks;
e) Umkristallisationsglühen des zweiten Werkstücks bei einer zweiten Temperatur von mindestens 875°C;
f) Wiederholen der Stufen b) bis e) gemäß Notwendigkeit der Erstellung der gewünschten Kornstruktur und Gefügeeinheitlichkeit;
g) drittes Absenken des zweiten Werkstücks auf eine erste Dicke zur Bildung einer ersten Pl
h) viertes Absenken der ersten Dicke der ersten Platte durch Querwalzen auf eine zweite Dicke zur Bildung einer zweiten Platte; und
i) Umkristallisationsglühen der zweiten Platte bei einer Temperatur von mindestens 875°C.

6. Verfahren gemäß Anspruch 5, worin die Stufen b) bis g) mindestens 1 Mal wiederholt werden.

7. Verfahren gemäß Anspruch 5, worin der Metallblock bei einer Temperatur unterhalb der Minimaltemperatur der Umkristallisation des genannten Blocks geschmiedet wird.

8. Verfahren gemäß Anspruch 5, worin der Metallblock ein Metall umfasst, das aus der Gruppe, bestehend aus Tantal, Tantallegierungen, Niob und aus Nioblegierungen, ausgewählt ist, wobei das genannte Metall eine Reinheit von mindestens 99,999 % aufweist.

9. Verwendung der mit dem Verfahren gemäß einem der Ansprüche 5 bis 8 hergestellten Metallplatte als Spucker-Target.

## Revendications

1. Plaque métallique réfractaire présentant une épaisseur, un centre et un bord, le métal étant sélectionné parmi le groupe constitué du tantale et du niobium, ledit métal ayant une pureté d'au moins 99,99 %, la plaque ayant une taille de grain inférieure à environ 40 microns et une texture qui est uniforme à la fois à travers ladite épaisseur et dudit centre jusqu'au dit bord, et où en outre ladite plaque métallique réfractaire présente
i) un mélange constant de grains ayant des orientations cristallographiques {100} et {111}, et
ii) une distribution d'orientations cristallographiques {100} et {111} qui varie de moins de 30 pour cent sur toute la surface d'un plan quelconque de ladite plaque métallique réfractaire, lesdits plans étant sélectionnés à partir des plans qui sont orthogonaux à l'épaisseur de ladite plaque métallique réfractaire et des plans qui sont en diagonale par rapport à l'épaisseur de ladite plaque métallique réfractaire, et
iii) une distribution d'orientations cristallographiques {100} et {111} qui varie de moins de 30 pour cent sur une épaisseur quelconque de ladite plaque métallique réfractaire.

2. Plaque métallique réfractaire selon la revendication 1, où ladite plaque métallique réfractaire est obtenue par un procédé comprenant un forgeage, un laminage et un recuit.

3. Plaque métallique réfractaire selon la revendication 1, dans laquelle la billette de métal comprend un métal sélectionné parmi le groupe constitué du tantale, d'alliages de tantale, du niobium, d'alliages de niobium, ledit métal ayant une pureté d'au moins 99,999 %.

4. Cible de pulvérisation comprenant une plaque selon l'une quelconque des revendications 1 à 3.

5. Procédé de fabrication d'une plaque métallique réfractaire, dans lequel le métal comprend un métal sélectionné parmi le groupe constitué du tantale, d'alliages de tantale, du niobium, d'alliages de niobium, ledit métal ayant une pureté d'au moins 99,99 %, une structure métallurgique fine et une structure uniforme comprenant les étapes consistant à :
a) fournir une pièce métallique réfractaire de départ,
b) réduire tout d'abord la longueur de la pièce métallique réfractaire de départ pour former une première pièce d'ouvrage en forgeant la billette à une épaisseur de billette souhaitée avec une réduction d'environ 35 % à 50 %, [premier forgeage 14]
c) effectuer un recuit de recristallisation de la première pièce d'ouvrage à une première température d'au moins 1370 °C,
d) deuxièmement réduire le diamètre de la première pièce d'ouvrage (forgeage de rappel) à un diamètre sensiblement identique au diamètre de la pièce métallique réfractaire de départ afin de former une seconde pièce d'ouvrage,
e) soumettre un recuit de recristallisation à la seconde pièce d'ouvrage à une seconde température d'au moins 875 °C,
f) répéter les étapes b) à e) autant que nécessaire pour obtenir la structure de grain et l'uniformité de texture souhaitées,
g) troisièmement réduire la seconde pièce d'ouvrage à une première épaisseur pour former une première plaque,
h) quatrièmement réduire la première épaisseur de la première plaque par laminage transversal à une seconde épaisseur pour former une seconde plaque, et
i) soumettre un recuit de recristallisation de la seconde plaque à une température d'au moins 875 °C.

6. Procédé selon la revendication 5, dans lequel les étapes b) à g) sont répétées au moins une fois.

7. Procédé selon la revendication 5, dans lequel la billette de métal est forgée à une température au-dessous de la température minimum de recristallisation de ladite billette.

8. Procédé selon la revendication 5, dans lequel la billette de métal comprend un métal sélectionné à partir du groupe constitué du tantale, d'alliages de tantale, du niobium, d'alliages de niobium, ledit métal ayant une pureté d'au moins 99,999 %.

9. Utilisation de la plaque métallique préparée par le biais du procédé selon l'une quelconque des revendications 5 à 8 en tant que cible de pulvérisation.
